# EUROPEAN PATENT APPLICATION

(11) **EP 4 563 720 A2**
(43) Date of publication of application: **04.06.2025**
(21) Application number: 24216449.9
(22) Date of filing: 29.11.2024
(51) Int. Cl.: C23C 18/12, C25D 1/04, C25D 3/38, C25D 5/12, C25D 5/34, C25D 5/48, C25D 5/00, C25D 7/06, H01M 4/00, H05K 3/38, C09D 5/00, C25D 5/10, H01M 4/66, H01M 4/70, H01M 10/0525

(54) **ELECTROLYTIC COPPER FOIL HAVING DOUBLE-SIDED LOOSE STRUCTURE, PREPARATION METHOD AND APPLICATION THEREOF**

(30) Priority: 30.11.2023 CN 202311630093
(71) Applicant: Jiujiang Defu Tech Co Ltd, Jiujiang, Jiangxi 332005 (CN)
(72) Inventor: Chen, RuYi, Jiujiang, 332005 (CN); Yang, HongGuang, Jiujiang, 332005 (CN); Zhang, Jie, Jiujiang, 332005 (CN); Shao, Yu, Jiujiang, 332005 (CN)
(74) Representative: Canzler & Bergmeier Patentanwälte Partnerschaft mbB

(57) **Abstract**

The present disclosure relates to an electrolytic copper foil having double-sided loose structure, preparation method and application thereof, which belongs to the technical field of electrolytic copper foil, and is to solve the problem that an electrolytic copper foil which can be applied in both anode of a lithium-ion battery and a printed circuit board is lacking in the prior art. The electrolytic copper foil comprises the following structures: a dense copper layer; a loose structure copper layer, grown on bi-directional surfaces of the dense copper layer; and a barrier layer, coated on the loose copper layer. The preparation method is divided into: preparation of dense copper layer by electrolyzing raw foil; preparation of loose structure copper layer; curing treatment; and optionally, silicone-containing organic layer treatment. It can be used in the field of lithium-ion battery and the field of printed circuit board. The present disclosure abandons the method of preparing copper foil having double-sided loose structure by etching, but uses electroplating process. Such a preparation process has batch and continuous production capacity, which can fundamentally solve the problem that the tensile strength of copper foil having double-sided loose structure is affected by the etching. And copper foil for printed circuit boards can be prepared by adding only one additional step.

## Description

### Cross-Reference to Related Application(s)

This application claims priority to Chinese Application No. 202311630093.1 filed on November 30, 2023, the disclosures of which are incorporated herein by reference in their entities.

### Field

The present disclosure relates to the technical field of electrolytic copper foil, and more specifically, to an electrolytic copper foil having double-sided loose structure, preparation method and application thereof.

### Background

Electrolytic copper foil, as an anode current collector of a lithium-ion battery, is an important part of the electrode structure of the lithium-ion battery. The electrolytic copper foil not only acts as the carrier of the anode active materials of the electrode in the battery, but also plays the role of collecting the transmission current, which has great influence on internal resistance, charge-discharge performance, and cycle performance of the lithium-ion battery. In addition, electrolytic copper foil is widely used in printed circuit boards and electronic components due to its high electrical and thermal conductivity, and is also one of the essential materials in electronic products.

In the prior art, the above two application directions of electrolytic copper foil do not overlap in the research.

Commercialized lithium ion batteries generally use copper foil with two smooth surfaces. Since preparation process of lithium copper foil use a variety of additive combinations to assist grain refinement growth to ensure that the copper foil has sufficient tensile strength and elongation, under the action of grain refinement, columnar crystal growth will be inhibited, and thus the surface roughness of the copper foil is generally low.

However, copper foil with low roughness is not an optimal choice for the lithium current collector. This is because the bonding strength between the copper foil with low roughness and the active materials are poor, and the active materials are easy to fall off, making it difficult to realize a high loading capacity, which affects the processing as well as the battery capacity; meanwhile, the wettability of the copper foil with low roughness is poor, so that the coating process of active materials is prone to poor processing. Furthermore, due to the low roughness, the contact interface area between the active materials and the current collector is small, which is unfavorable to the rapid export of electrons, and is easy to generate interfacial resistance, which affects the rapid charge and discharge of the battery. The Chinese patent No. CN202110638179.3, titled "COPPER FOIL WITH TWO ROUGH SURFACES AND PREPARATION METHOD THEREOF", provides obtaining lithium copper foil with high specific surface area by etching with etching solution to increase the peeling strength of the copper foil and the active materials. However, the etching method used is time-consuming, difficult to control, and difficult for mass production. There is also a risk of decreasing the tensile strength of the copper foil having double-sided loose structure prepared by the etching method.

Therefore, how to prepare a copper foil having double-sided loose structure with large specific surface area and high roughness in a mass production manner is a new research direction.

On the other hand, browning process is commonly used in the printed circuit manufacturing process to slightly etch the non-laminated copper surface of the inner board, so as to increase the specific surface area of the copper foil, improve the roughness, and achieve the purpose of enhancing the bonding force between the memory board and the PP. However, the browning process has disadvantages of, for example, long process, low efficiency, complicated control, high cost and environmental pollution.

How to meet the bonding strength requirements between the memory board and the PP through non-browning process is a problem to be solved, further directing to the increase of the specific surface area of the copper foil and the improvement of the roughness.

Based on the above background, the above two application directions are not related at present. Our researchers and developers combine the above two application directions, and provide an electrolytic copper foil having double-sided loose structure, preparation method and application thereof.

### Summary

The present disclosure aims to provide an electrolytic copper foil having double-sided loose structure, preparation method and application thereof, so as to solve the problem that an electrolytic copper foil which can be applied in both anode of a lithium-ion battery and a printed circuit board is lacking in the prior art.

In order to solve the above problems, the technical solution of the present disclosure is as follows.

An electrolytic copper foil having double-sided loose structure is characterized in that the copper includes the following structures: a dense copper layer; a loose structure copper layer, grown on bi-directional surfaces of the dense copper layer; and a barrier layer, coated on the loose copper layer.

An overall thickness of the dense copper layer and the cooper foil is 4.5 µm-70 µm.

The loose structure copper layer has a thickness of 0.5µm-2µm, and its morphology is a combination of one or more of needle tip, round granule, long granule, whisker and cluster.

The barrier layer is composed of one or more electrodeposited metals of chromium (Cr), zinc (Zn), tin (Sn), molybdenum (Mo), cobalt (Co), tungsten (W), and nickel (Ni).

Further, a modified barrier layer formed by applying a silicone-containing organic coating to a surface layer of the barrier layer and modifying. The modified barrier layer is a silicone-containing organic coating, which is composed of a combination of two of epoxy silane, amino-silane, mercapto-silane, vinyl silane, cyano-silane, and methacryloyloxy-silane.

Further, the tensile strength of the dense copper layer ranges from 475Mpa to 685Mpa. The elongation of the dense copper layer ranges from 3.5% to 16.8%. The roughness Rz of the dense copper layer obtained by smooth surface contact method ranges from 0.8µm to 1.5µm, and the roughness Rz of the dense copper layer obtained by rough surface contact method ranges from 0.8µm to 1.3µm. The roughness Rz obtained by method of contacting the upper surface A and the lower surface B of the loose structure copper layer is greater than 2.7µm, the specific surface area obtained by non-contact method is above 1.3, and Spd is ranges from 30,000/mm2 to 40,000/mm2.

The method for manufacturing the afore-mentioned electrolytic copper foil having double-sided loose structure comprises the following steps.

### S1: Preparation of dense copper layer by electrolyzing raw foil.

Prepare a copper foil with two smooth surfaces in size of 4.5µm-70µm by an electrolytic machine, and an electrolyte additive formulation is a combination of two types of functional additives, wherein:
A leveling agent, or called a throwing agent, is a combination of any two or three of collagen, hydroxyethyl cellulose, polyethyleneimine, polyethylene glycol, sulfamic acid, ammonium iminodiacetate, polyetheramine, and polyetheramide.

A brightener is one of thiourea, sodium sulfite, sodium sulfide, sodium polydithiodipropane sulfonate, and N-hydroxyethylbenzenesulfonamide.

The mass ratio of the leveling agent (or the throwing agent) to the brightener is 3:1, and the total concentration of the additive ranges from 30mg/L to 50mg/L.

Finally, the dense copper layer of the copper foil with two smooth surfaces is prepared.

Compared with the traditional electrolysis of a double-sided smooth lithium foil, the present electrolysis process does not require to perform anti-oxidation treatment.

### S2: Preparation of loose structure copper layer.

A loose structure copper layer is prepared on the basis of a dense copper layer by pickling, roughening, curing, and washing.

### S2.1: Pickling treatment.

Put the copper foil with two smooth surfaces obtained in S1 into a pickling tank for pickling, and wash off the oxide layer on the surface of the copper foil.

### S2.2: Roughening treatment.

Perform roughening treatment on the copper foil with two smooth surfaces obtained in S2.1, whose oxide layer has washed away, and plate copper nodule particles on the surface of the foil by applying electric current. The microstructure of a treated copper nodule is a combination of one or more of needle tip, round granule, long granule, whisker and cluster. Form a preliminarily roughened copper foil.

After the roughening treatment, wash the foil surface with water to reduce the contamination of the electrolyte adsorbed on the surface of the copper foil to the subsequent tank solution.

### S2.3: Curing treatment.

Continue to pass the preliminarily roughened copper foil obtained in S2.2 through a curing tank. Perform smooth copper plating treatment by applying current to the surface of the foil, and continuously improve the roughness of the copper nodule. Meanwhile, fix the needle tip shaped copper structure after the roughening treatment, avoiding the copper nodule on the surface of the copper foil from falling off.

The thickness of the copper foil after the curing treatment will increases. The thickness of a roughening layer can be adjusted by roughening and curing current magnitude. Eventually, the loose structure copper layer is grown on the basis of the dense copper layer of the copper foil with two smooth surfaces obtained in S1.

### S2.4: Washing.

Wash the foil surface of the cured copper foil in S2.3 with water, and a product obtained is a rough copper foil with a loose structure copper layer grown on both sides.

### S3: Electroplating treatment on barrier layer.

Electrochemically deposite a metal layer on the loose structure copper layer of the rough copper foil obtained in S2.4, and eventually form a barrier layer coated on the loose structure copper layer, which serves the purpose of slowing down the oxidization of the copper foil. The metal of the barrier layer is a combination of one or two of chromium, zinc, tin, molybdenum, cobalt, tungsten, and nickel.

A final product obtained after washing and drying is an electrolytic copper foil having double-sided loose structure.

Further, the additive in the roughening treatment of S2.2 is a combination of two or three of sodium molybdate, sodium tungstate, polyvinyl alcohol, polyvinyl pyrrolidone, and polypyrrole, and a total concentration of the additive ranges from 10mg/L to 30mg/L.

Further, the metal of the barrier layer of the electrolytic copper foil having double-sided loose structure in S3 is chromium.

The application of the electrolytic copper foil having double-sided loose structure prepared in the above steps S1-S3 is that the copper foil can be applied to a lithium-ion battery, which is applied to automotive power batteries, energy storage systems, and consumer electronics.

Further, the metal of the barrier layer of the electrolytic copper foil having double-sided loose structure in S3 is a combination of one or two of zinc, tin, molybdenum, cobalt, tungsten, and nickel.

The method of the present disclosure further includes: S4, silicone-containing organic layer treatment.

Perform surface coating with a silane treatment agent on the electrolytic copper foil having double-sided loose structure with the surface containing metal layer obtained in S3 to improve the compatibility between the copper foil and the prepreg, as well as improve the peeling strength between the copper foil and the substrate.

The concentration of silicon after full hydrolysis in the silane treatment agent ranges from 0.5g/L to 2g/L.

Finally, a product obtained after washing and drying is another electrolytic copper foil having double-sided loose structure.

Further, the silane treatment agent is a combination of two of epoxy silane, amino-silane, mercapto-silane, vinyl silane, cyano-silane, and methacryloyloxy-silane, wherein a ratio of the mass concentration of the two is 1:1-3. A total concentration of the additive is 1.5wt%.

The application of the electrolytic copper foil having double-sided loose structure prepared in the above steps S1-S4 is that the copper foil can be applied to a printed circuit board, which is applied to communication, radar, and electronic products.

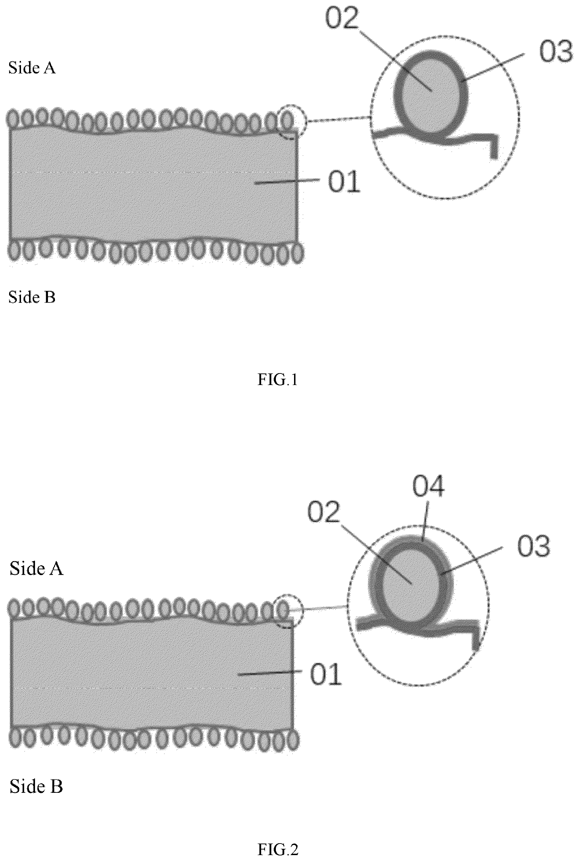

The invention has the following beneficial effects:
(1) In the product prepared by the present disclosure, the dense copper layer is prepared by electrolysis. By introducing multiple additives, the dense copper layer obtained by electrolysis has similar roughness of the two sides, high tensile strength, and high elongation. The dense copper layer act as a substrate for the growth of subsequent copper layer with loose structure on the surface. The copper layer with loose structure is prepared by electrolysis on both side A and side B of the dense copper layer, and through the roughing and curing process, it may realize the loose structure of needle tip, round granule, long granule, whisker, cluster, and other forms of shape. The copper layer with loose structure has the characteristics of large specific surface area and high roughness. The barrier layer is a dense film formed on the surface of the copper by electrochemical deposition, which prevents the active copper metal from reacting with air, water vapor and acid-base environment, so that the surface of the copper foil is anti-oxidant and chemical resistant. The modified barrier layer is obtained by performing surface modification through coating. The coated silicone-containing organic layer provides the copper foil with a certain degree of oxidation resistance as well as good compatibility with prepreg.
(2) In the application of the product of the present disclosure, the electrolytic copper foil having double-sided loose structure used for lithium-ion batteries is composed of a dense copper layer (01), a loose structure copper layer (02) grown on the bi-directional surfaces of the dense copper layer, and a barrier layer (03) coated on the loose copper layer in an order from inside to outside. The barrier layer is deposited with chromium, and the chromium layer serves to prevent oxidation of the copper foil. A structure is shown in FIG.1.

Compared with the traditional copper foil with two smooth surfaces of the lithium battery, the electrolytic copper foil having double-sided loose structure of the present disclosure has greater roughness, which makes the bonding strength between copper foil and active materials greater. Thus, the unit area load of the electrode active materials is larger, and the capacity of the battery is larger.

Compared with the traditional copper foil with two smooth surfaces of the lithium battery, the electrolytic copper foil having double-sided loose structure of the present disclosure has better wettability, which can improve the compatibility between copper foil and electrode material, reduce the risk of uneven thickness in the process of coating electrode material, and improve the performance and life of the battery.

Compared with the traditional copper foil with two smooth surfaces of the lithium battery, the electrolytic copper foil having double-sided loose structure of the present disclosure has larger specific surface area, which makes the contact interface area between the active materials and the current collector larger, which is favorable to the rapid export of electrons, and makes it easy to generate interfacial resistance, which is favorable to the rapid charge and discharge of the battery.

The electrolytic copper foil having double-sided loose structure used for printed circuit boards is composed of a dense copper layer (01), a loose structure copper layer (02) grown on the bi-directional surfaces of the dense copper layer, a barrier layer (03) coated on the loose copper layer, and a modified barrier layer in an order from inside to outside, wherein the barrier layer is deposited with one or two metal among zinc, tin, molybdenum, cobalt, tungsten, and nickel. The composite of the modified barrier layer is silane treatment agent. A structure is shown in FIG.2.

Compared with the barrier layer (03) of the copper foil used for lithium-ion batteries, the modified barrier layer not only plays a role in resisting oxidation at normal temperature and high temperature, but also plays a role in chemical resistance.

Compared with the traditional electrolytic copper foil for printed circuit boards, in the present disclosure, a copper foil with large specific surface area and high roughness can be obtained without browning process. Such a copper foil can enhance the bonding force between inner plate and prepreg, and meet the bonding strength requirements between the memory board and the PP. If applied, it may improve the manufacturing efficiency of circuit boards, and reduce material waste and environmental pollution caused by the browning process.

(3) The method of the present disclosure abandons the method of preparing copper foil having double-sided loose structure by etching, but uses electroplating process. Such a preparation process has batch and continuous production capacity, which can fundamentally solve the problem that the tensile strength of copper foil having double-sided loose structure is affected by the etching.

Moreover, the method of the present disclosure can be used for preparing copper foil for printed circuit boards on the basis of the preparation of copper foil for lithium ion batteries, without changing the configuration of the original production line. Simply by adjusting the additives and dosage in each process step, and subsequently introducing a modified barrier coating step, it can then be used to prepare copper foil for printed circuit boards.

That is to say, the technical correlation of copper foil in different application directions is realized, and in the process of industrialization, the two production lines can be combined, which makes remarkable economy.

### Brief Description of the Drawings

FIG.1 illustrates a schematic diagram of an electrolytic copper foil having double-sided loose structure prepared in Embodiment I. (Copper foil for a lithium ion battery)
FIG.2 illustrates a schematic diagram of an electrolytic copper foil having double-sided loose structure prepared in Embodiment II. (Copper foil for a printed circuit board)
FIG.3 illustrates a process flow chart of the double-sided loose structure prepared in Embodiment I. (Copper foil for a lithium ion battery)
FIG.4 illustrates a process flow chart of the double-sided loose structure prepared in Embodiment IV. (Copper foil for a printed circuit board)
FIG.5 illustrates a SEM image (magnification of 8KX) of side A (left) and side B (right) of the electrolytic copper foil having double-sided loose structure of product I in Embodiment I.
FIG.6 illustrates a SEM image (magnification of 5KX) of cross section of the copper foil having double-sided loose structure of product I in Embodiment I.
FIG.7 illustrates a SEM image (magnification of 8KX) of side A (left) and side B (right) of the electrolytic copper foil having double-sided loose structure of product II in Embodiment II.
FIG.8 illustrates a SEM image (magnification of 8KX) of side A (left) and side B (right) of the electrolytic copper foil having double-sided loose structure of product III in Embodiment III.
FIG.9 illustrates a SEM image (magnification of 8KX) of side A (left) and side B (right) of the electrolytic copper foil having double-sided loose structure of product IV in Embodiment IV.
FIG.10 illustrates a SEM image (magnification of 8KX) of side A (left) and side B (right) of the electrolytic copper foil having double-sided loose structure of product V in Embodiment V.
FIG.11 illustrates a SEM image (magnification of 8KX) of side A (left) and side B (right) of the electrolytic copper foil having double-sided loose structure of product VI in Embodiment VI.
FIG.12 illustrates a SEM image (magnification of 2KX) of side A (left) and side B (right) of a copper foil with two smooth surfaces without loose structure of product VII in Comparative example I.
FIG.13 illustrates a SEM image (magnification of 8KX) of side A (left) and side B (right) of the electrolytic copper foil having double-sided loose structure without roughening additive treatment of product VIII in Comparative example II.
FIG.14 illustrates a SEM image (magnification of 8KX) of side A (left) and side B (right) of the electrolytic copper foil having double-sided loose structure without curing treatment of product XI in Comparative example III.
FIG.15 illustrates a schematic diagram of peeling strength test of electrode materials.

### Detailed Description of Embodiments

In order to make the objects, technical solutions, and advantages of embodiments of the present disclosure more clear, hereinafter, the technical solutions in the embodiments of the present disclosure will be described clearly and completely in conjunction with the accompanying drawings in the implementations of the present disclosure. Obviously, the described embodiments are a part of the embodiments of the present disclosure, and not all of the embodiments. Based on the implementations in the present disclosure, all other implementations obtained by a person of ordinary skill in the art without making creative work fall within the scope of protection of the present disclosure.

Therefore, the following detailed description of the embodiments of the present disclosure provided in the accompanying drawings is not intended to limit the scope of the invention for which protection is claimed, but merely illustrates selected implementations of the present disclosure.

Embodiment I: Preparation of an electrolytic copper foil having double-sided loose structure for a lithium-ion battery.

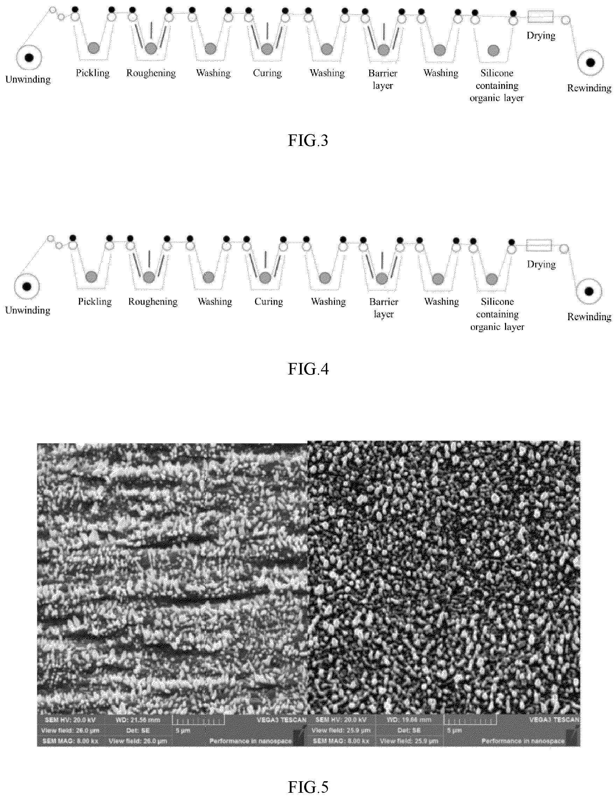

As shown in FIG.3:
S1: Preparation of dense copper layer I by electrolyzing raw foil.

Prepare a double-sided smooth lithium copper foil in size of 6 µm by an electrolytic machine.

The electrolytic process parameters are controlled in the following ranges:
Concentration of Cu2+ of electrolyte: 90-110g/L.
Concentration of H2SO4: 100-140g/L.
Concentration of Cl-: 15-25mg/L.
Current density: 70-80A/dm2.

In the electrolytic process, the additive is a mixed additive of hydroxyethyl cellulose, polyethylene glycol and sodium polydithiodipropane sulfonate, wherein a ratio of the mass concentration of the three is 2:1:1. A total concentration of the additive is 50mg/L.

The final obtained dense copper layer I of the two smooth surfaces has a measured thickness of 6.2µm. The tensile strength of the copper foil is 610Mpa, the elongation is 5.6%, the roughness Rz of smooth surface is 1.0µm, and the roughness Rz of rough surface is 1.2µm.

Compared with the traditional electrolysis of a double-sided smooth lithium foil, the present electrolysis process does not perform anti-oxidation treatment.

### S2: Preparation of loose structure copper layer (02).

The loose structure copper layer (02) is prepared on the basis of a dense copper layer (01) by pickling, roughening, curing, and washing.

### S2.1: Pickling treatment.

Put the copper foil with two smooth surfaces obtained in S1 into a pickling tank for pickling, and wash off the oxide layer on the surface of the copper foil.

The pickling process parameters are controlled in the following ranges:
Concentration of H2SO4 of the pickling solution: 100-140g/L.
Temperature: 25-30°C.

### S2.2: Roughening treatment.

Perform roughening treatment on the copper foil with two smooth surfaces obtained in S2.1, whose oxide layer has washed away, and plate copper nodule particles on the surface of the foil by applying electric current. The microstructure characteristic of a treated copper nodule is needle tip, and form a preliminarily roughened copper foil.

The roughening process parameters are controlled in the following ranges:
Concentration of H2SO4 of the roughening solution: 100-140g/L.
Concentration of Cu2+: 15-25g/L.

The additive for the roughening solution is a mixed additive of sodium molybdate and sodium tungstate, wherein a ratio of the mass concentration of the two is 1:1. A total concentration of the additive is 10mg/L.
Temperature: 25-30°C.
Flow rate: 5-8m3/h.

The current density at inlet end is 20-22A/dm2, the current density at middle is 25-27A/dm2, and the current density at outlet end is 15-17A/dm2.

After the roughening treatment, the foil surface will be washed with water. The purpose is to reduce the contamination of the electrolyte adsorbed on the surface of the copper foil to the subsequent tank solution.

### S2.3: Curing treatment.

Continue to pass the preliminarily roughened copper foil obtained in S2.2 through a curing tank. Perform smooth copper plating by applying current to the surface of the foil, and continuously improve the roughness of the copper nodule. Meanwhile, fix the needle tip shaped copper structure after the roughening treatment, avoiding the copper nodule on the surface of the copper foil from falling off.

The curing process parameters are controlled in the following ranges:
Concentration of Cu2+ of the curing solution: 55-60g/L.
Concentration of H2SO4: 100±110 g/L.
Temperature: 50-55°C.
Flow rate: 6-10m3/h.

The current density at inlet end is 13-15A/dm2, the current density at middle is 17-19A/dm2, and the current density at outlet end is 11-13A/dm2.

The thickness of the copper foil after the curing will increases. The thickness of a roughening layer can be adjusted by roughening and curing current magnitude. Eventually, the loose structure copper layer (02) is grown on the basis of the dense copper layer (01) of the copper foil with two smooth surfaces obtained in S1, and the thickness of the loose structure copper layer (02) is about 0.5µm.

### S2.4: Washing.

Wash the foil surface of the cured copper foil in S2.3 with water, and a product obtained is a rough copper foil with a loose structure copper layer (02) grown on both sides.

### S3: Electroplating treatment on barrier layer.

Electrochemically deposite a metal layer on the loose structure copper layer (02) of the rough copper foil obtained in S2.4, and eventually form a barrier layer (03) coated on the loose copper layer, which serves the purpose of slowing down the oxidization of the copper foil.

The barrier layer (03) in the present embodiment is chromium electroplating. The electroplating process parameters are as follows.
Concentration of Cr6+: 1.0g/L.
Temperature: 33°C, and pH: 9.8.
Flow rate: 7m3/h.

The current density at inlet end is 1OA/dm2, the current density at middle is 15A/dm2, and the current density at outlet end is 7A/dm2.

Perform washing, and drying at 120°C. The product I finally obtained is an electrolytic copper foil having double-sided loose structure, and the thickness of the final copper foil of product I is 6.7µm.

It is found by placing the product I under the electron microscope that:
The SEM image of both sides A and B of the electrolytic copper foil having double-sided loose structure of product I is shown in FIG.5. It can be seen that fine copper nodule particles are uniformly distributed on the surface of the copper foil, with a structure characteristic of needle tip. The copper nodules grow independently of each other.

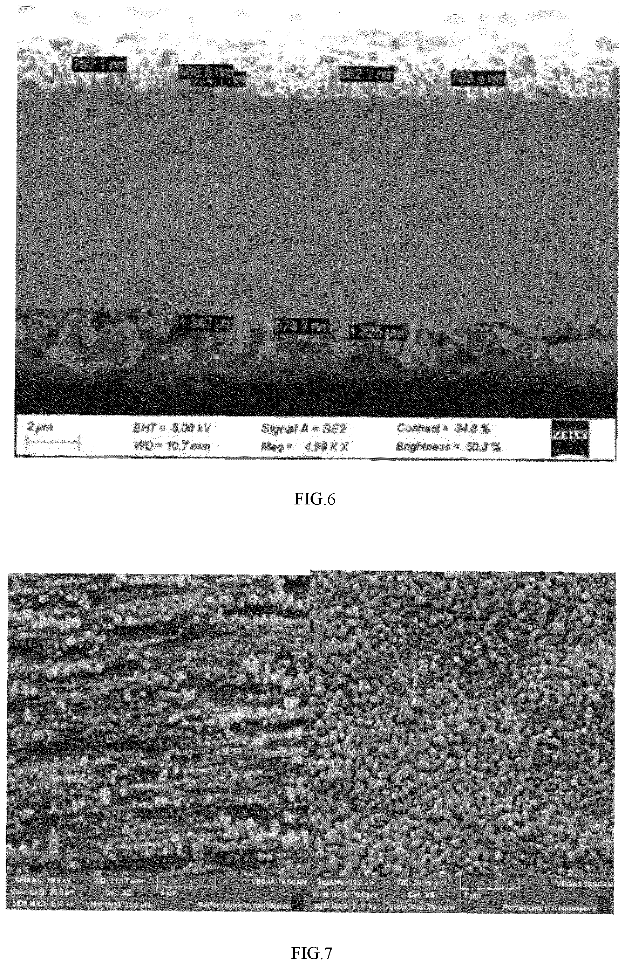

The SEM image of cross section of the copper foil having double-sided loose structure of product I is shown in FIG.6. The height of copper teeth ranges from 700nm to 1.5µm.

Embodiment II: Preparation of an electrolytic copper foil having double-sided loose structure for a lithium-ion battery.

Differences from Embodiment I are:
(1) In S1, Preparation of dense copper layer I by electrolyzing raw foil:
   Prepare a double-sided smooth lithium copper foil in size of 8µm by an electrolytic machine.

In the electrolytic process, the additive is a mixed additive of hydroxyethyl cellulose, polyethyleneimine, and thiourea, wherein a ratio of the mass concentration of the three is 2:1:1. A total concentration of the additive is 40mg/L.

The final obtained dense copper layer I of the two smooth surfaces has a measured thickness of 8.1µm. The tensile strength of the copper foil is 550Mpa, the elongation is 6.3%, the roughness Rz of smooth surface is 1.1µm, and the roughness Rz of rough surface is 1.2µm.

### (2) In S2.2, Roughening treatment:

The additive for the roughening solution is a mixed additive of sodium molybdate and sodium tungstate, wherein a ratio of the mass concentration of the two is 1:1. A total concentration of the additive is 10mg/L.

The microstructure characteristic of a treated copper nodule is round granule.

### (3) After S2.3, Curing treatment:

Eventually, the loose structure copper layer (02) is grown on the basis of the dense copper layer (01) of the copper foil with two smooth surfaces obtained in S1, and the thickness of the loose structure copper layer (02) is about 1.1µm .

### (4) In S3, Electroplating treatment on barrier layer:

The barrier layer (03) is chromium electroplating. The electroplating process parameters are as follows.
Concentration of Cr6+: 1.5g/L.
Temperature: 34°C, and pH: 10.

Finally, after washing and drying, the obtained product II is an electrolytic copper foil having double-sided loose structure, and the thickness of the final copper foil of product II is 9.2µm.

The SEM image of both sides A and B of the electrolytic copper foil having double-sided loose structure of product II is shown in FIG.7. The microstructure characteristic of the copper nodule is round granule.

Embodiment III: Preparation of an electrolytic copper foil having double-sided loose structure for a lithium-ion battery.

Differences from Embodiment I are:
(1) In S1, Preparation of dense copper layer I by electrolyzing raw foil:
   Prepare a double-sided smooth lithium copper foil in size of 4.5µm by an electrolytic machine.

In the electrolytic process, the additive is a mixed additive of hydroxyethyl cellulose, sulfamic acid, and N-hydroxyethylbenzenesulfonamide, wherein a ratio of the mass concentration of the three is 2:1:1. A total concentration of the additive is 50mg/L.

The final obtained dense copper layer I of the two smooth surfaces has a measured thickness of 4.6µm. The tensile strength of the copper foil is 685Mpa, the elongation is 3.5%, the roughness Rz of smooth surface is 1.2µm, and the roughness Rz of rough surface is 1.3µm.

### (2) In S2.2, Roughening treatment:

The additive for the roughening solution is a mixed additive of sodium molybdate, sodium tungstate and polyvinyl alcohol, wherein a ratio of the mass concentration of the three is 1:0.5:0.5. A total concentration of the additive is 20mg/L.

The microstructure characteristic of a treated copper nodule is long granule.

### (3) After S2.3, Curing treatment:

Eventually, the loose structure copper layer (02) is grown on the basis of the dense copper layer (01) of the copper foil with two smooth surfaces obtained in S1, and the thickness of the loose structure copper layer (02) is about 1.2µm.

### (4) In S3, Electroplating treatment on barrier layer:

The barrier layer (03) is chromium electroplating. The electroplating process parameters are as follows.
Concentration of Cr6+: 2g/L.
Temperature: 10.2°C, and pH: 7.

Finally, after washing and drying, the obtained product III is an electrolytic copper foil having double-sided loose structure, and the thickness of the final copper foil of product III is 5.8µm.

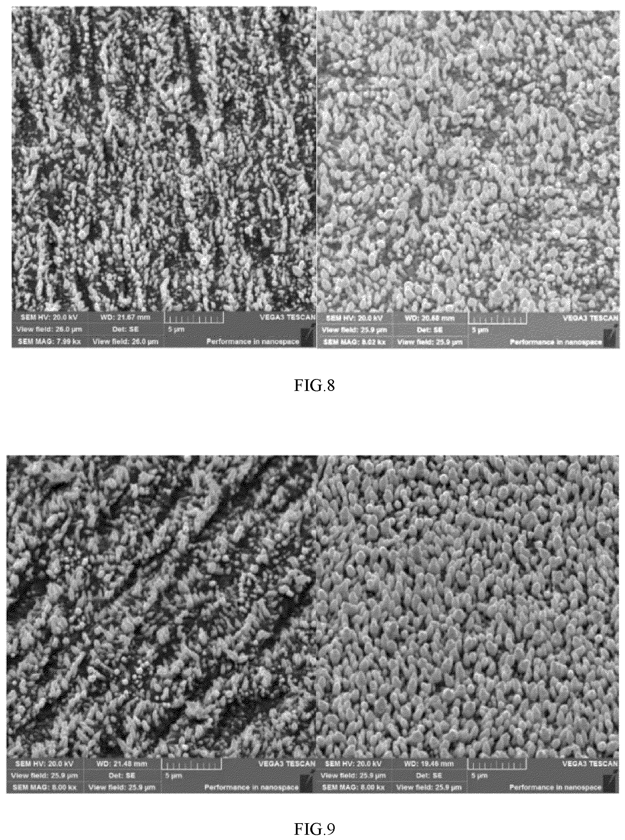

The SEM image of both sides A and B of the electrolytic copper foil having double-sided loose structure of product III is shown in FIG.8. The microstructure characteristic of the copper nodule is long granule.

Embodiment IV: Preparation of an electrolytic copper foil having double-sided loose structure for a printed circuit board.

As shown in FIG.4:
Differences from Embodiment I are:
(1) In S1, Preparation of dense copper layer I by electrolyzing raw foil:
   Prepare a double-sided smooth lithium copper foil in size of 35µm by an electrolytic machine.

In the electrolytic process, the additive is a mixed additive of collagen, ammonium iminodiacetate, and sodium sulfide, wherein a ratio of the mass concentration of the three is 2:1:1. A total concentration of the additive is 30mg/L.

The final obtained dense copper layer I of the two smooth surfaces has a measured thickness of 35.1µm. The tensile strength of the copper foil is 492Mpa, the elongation is 11.2%, the roughness Rz of smooth surface is 0.8µm, and the roughness Rz of rough surface is 1.1µm.

### (2) In S2.2, Roughening treatment:

The additive for the roughening solution is a mixed additive of sodium tungstate, and polyvinyl alcohol, wherein a ratio of the mass concentration of the two is 1:1. A total concentration of the additive is 20mg/L.

The microstructure characteristic of a treated copper nodule is whisker.

### (3) After S2.3, Curing treatment:

Eventually, the loose structure copper layer (02) is grown on the basis of the dense copper layer (01) of the copper foil with two smooth surfaces obtained in S1, and the thickness of the loose structure copper layer (02) is about 1.8µm.

### (4) In S3, Electroplating treatment on barrier layer:

The barrier layer (03) is zinc and tin electroplating. The electroplating process parameters are controlled in the following ranges:
Concentration of Sn2+: 0.4-0.6g/L.
Concentration of Zn2+: 1.0-1.5g/L.
Concentration of K4P2O7: 40-50g/L.
Temperature: 33-35°C, and pH: 9.8-10.2.
Flow rate: 5-7m3/h.

The current density at inlet end is 15A/dm2, the current density at middle is 20A/dm2, and the current density at outlet end is 8A/dm2.

### S4, silicone-containing organic layer treatment.

Perform surface coating with a silane treatment agent after washing the electrolytic copper foil having double-sided loose structure with the surface containing metal layer obtained in S3 to improve the compatibility between the copper foil and the prepreg, and to improve the peeling strength between the copper foil and the prepreg.

The silane treatment agent is a mixed additive of epoxy silane and amino-silane, wherein a ratio of the mass concentration of the two is 1:3. A total concentration of the additive is 1.5wt%. The concentration of silicon after full hydrolysis in the silane treatment agent ranges from 0.5g/L to 2g/L.

Finally, perform washing and drying at 100-150°C. The product IV finally obtained is an electrolytic copper foil having double-sided loose structure, and the thickness of the final copper foil is measured as 36.9µm.

The SEM image of both sides A and B of the electrolytic copper foil having double-sided loose structure of product IV is shown in FIG.9. The microstructure characteristic of the copper nodule is whisker.

Embodiment V: Preparation of an electrolytic copper foil having double-sided loose structure for a printed circuit board.

Differences from Embodiment IV are:
(1) In S1, Preparation of dense copper layer I by electrolyzing raw foil:
   Prepare a double-sided smooth lithium copper foil in size of 9µm by an electrolytic machine.

In the electrolytic process, the additive is a mixed additive of collagen, polyetheramine, and sodium polydithiodipropane sulfonate, wherein a ratio of the mass concentration of the three is 2:1:1. A total concentration of the additive is 40mg/L.

The final obtained dense copper layer I of the two smooth surfaces has a measured thickness of 9.1µm. The tensile strength of the copper foil is 525Mpa, the elongation is 7.9%, the roughness Rz of smooth surface is 1.3µm, and the roughness Rz of rough surface is 1.0µm.

### (2) In S2.2, Roughening treatment:

The additive for the roughening solution is a mixed additive of sodium tungstate, polyvinyl alcohol, and polyvinyl pyrrolidone, wherein a ratio of the mass concentration of the three is 1:0.5:0.5. A total concentration of the additive is 30mg/L.

The microstructure characteristic of a treated copper nodule is cluster.

### (3) After S2.3, Curing treatment:

Eventually, the loose structure copper layer (02) is grown on the basis of the dense copper layer (01) of the copper foil with two smooth surfaces obtained in S1, and the thickness of the loose structure copper layer (02) is about 2.0µm.

### (4) In S3, Electroplating treatment on barrier layer:

The barrier layer (03) is molybdenum and cobalt electroplating. The electroplating process parameters are controlled in the following ranges:
Concentration of MnO42+: 0.8-1.1g/L.
Concentration of Co2+: 3.5-3.7g/L.
Concentration of K4P2O7: 42-44g/L.
Temperature: 28-30°C, and pH: 8.7-9.0.
Flow rate: 5-7m3/h.

The current density at inlet end is 20A/dm2, the current density at middle is 25A/dm2, and the current density at outlet end is 15A/dm2.

### S4, silicone-containing organic layer treatment.

Perform surface coating with a silane treatment agent after washing the electrolytic copper foil having double-sided loose structure with the surface containing metal layer obtained in S3 to improve the compatibility between the copper foil and the prepreg, and to improve the peeling strength between the copper foil and the prepreg.

The silane treatment agent is a mixed additive of mercapto-silane and vinyl silane, wherein a ratio of the mass concentration of the two is 1:1. A total concentration of the additive is 1.5wt%. The concentration of silicon after full hydrolysis in the silane treatment agent is 1.2g/L.

Finally, perform washing and drying at 100-150°C. The product V finally obtained is an electrolytic copper foil having double-sided loose structure, and the thickness of the final copper foil is measured as 11.1µm.

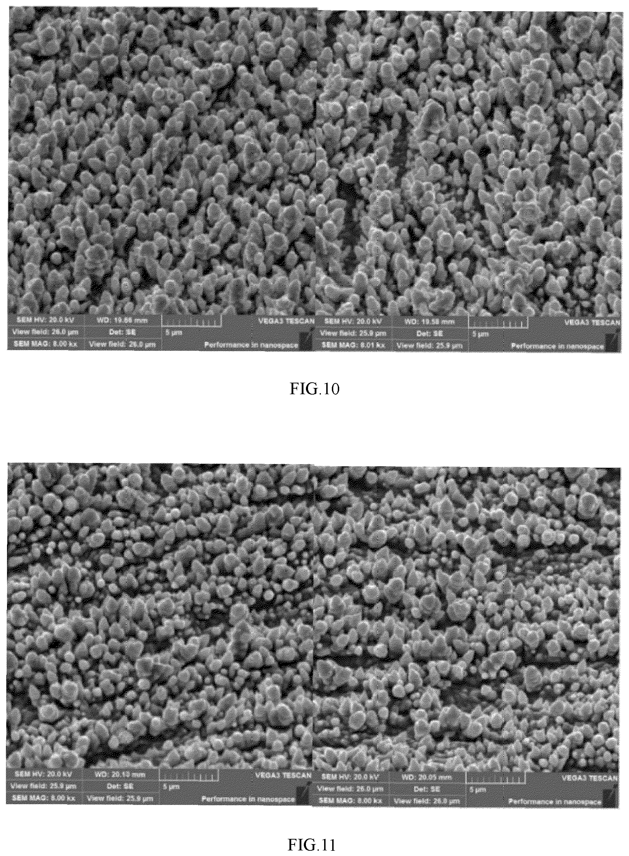

The SEM image of both sides A and B of the electrolytic copper foil having double-sided loose structure of product V is shown in FIG.10. The microstructure characteristic of the copper nodule is cluster.

Embodiment VI: Preparation of an electrolytic copper foil having double-sided loose structure for a printed circuit board.
(1) In S1, Preparation of dense copper layer I by electrolyzing raw foil:
   Prepare a double-sided smooth lithium copper foil in size of 70µm by an electrolytic machine.

In the electrolytic process, the additive is a mixed additive of collagen, ammonium iminodiacetate, polyetheramide, and sodium sulfite, wherein a ratio of the mass concentration of the four is 2:0.5:0.5:1. A total concentration of the additive is 30mg/L.

The final obtained dense copper layer I of the two smooth surfaces has a measured thickness of 70.2µm. The tensile strength of the copper foil is 475Mpa, the elongation is 16.8%, the roughness Rz of smooth surface is 1.5µm, and the roughness Rz of rough surface is 0.8µm.

### (2) In S2.2, Roughening treatment:

The additive for the roughening solution is a mixed additive of sodium tungstate and polypyrrole, wherein a ratio of the mass concentration of the two is 1:1. A total concentration of the additive is 30mg/L.

The microstructure characteristic of a treated copper nodule is mingled up with whisker and long granule.

### (3) After S2.3, Curing treatment:

Eventually, the loose structure copper layer (02) is grown on the basis of the dense copper layer (01) of the copper foil with two smooth surfaces obtained in S1, and the thickness of the loose structure copper layer (02) is about 2µm.

### (4) In S3, Electroplating treatment on barrier layer:

The barrier layer (03) is tungsten and nickel electroplating. The electroplating process parameters are controlled in the following ranges:
Concentration of WO42+: 1.3-1.4g/L.
Concentration of Ni2+: 2.2-2.5g/L.
Concentration of K4P2O7: 49-51g/L.
Temperature: 35-37°C, and pH: 8.5-8.8.
Flow rate: 5-7m3/h.

The current density at inlet end is 15A/dm2, the current density at middle is 20A/dm2, and the current density at outlet end is 15A/dm2.

### S4, silicone-containing organic layer treatment.

Perform surface coating with a silane treatment agent after washing the electrolytic copper foil having double-sided loose structure with the surface containing metal layer obtained in S3 to improve the compatibility between the copper foil and the prepreg, and to improve the peeling strength between the copper foil and the prepreg.

The silane treatment agent is a mixed additive of cyano-silane and methacryloyloxy-silane, wherein a ratio of the mass concentration of the two is 1:1.5. A total concentration of the additive is 1.5wt%. The concentration of silicon after full hydrolysis in the silane treatment agent is 2g/L.

Finally, perform washing and drying at 100-150°C. The product VI finally obtained is an electrolytic copper foil having double-sided loose structure, and the thickness of the final copper foil is measured as 72.2µm.

The SEM image of both sides A and B of the electrolytic copper foil having double-sided loose structure of product VI is shown in FIG.11. The microstructure characteristic of the copper nodule is mingled up with whisker and long granule.

The above is specific implementation process of the solution recited in the present disclosure. Hereinafter, important steps and parameters of the present disclosure are adjusted to form comparative examples, so as to compare the differences between the prepared products when steps and parameters are different.

### Comparative example I

Compared with Embodiment I, the differences are that:
After the completion of the preparation (S1) of dense copper layer I by electrolyzing raw foil, do not perform the preparation (S2) of loose structure copper layer (02), and directly perform electroplating treatment on barrier layer without changing electroplating process parameters.

The electrolytic copper foil finally obtained is product VII.

The thickness of the final copper foil of product VII is 6.1 µm.

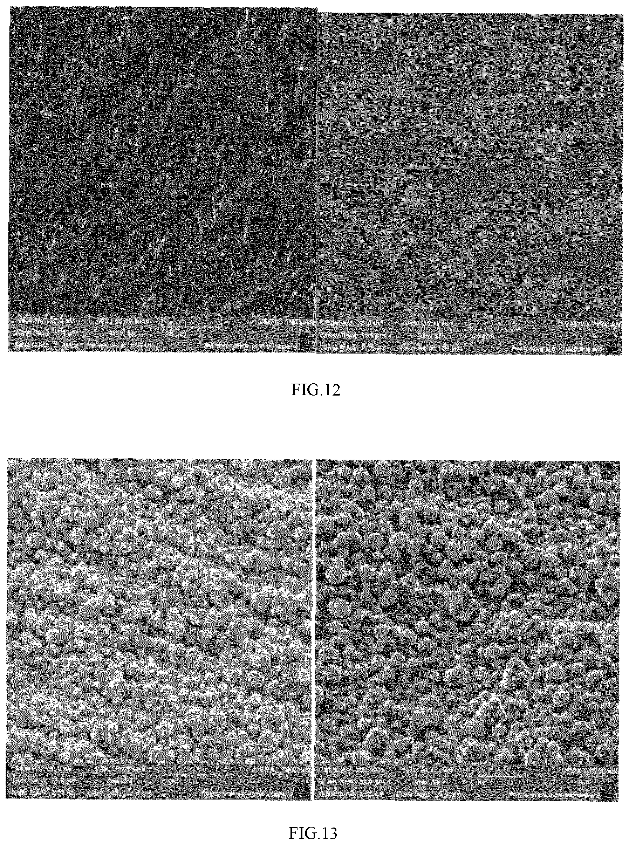

The SEM image of both sides A and B of product VII is shown in FIG.12.

By comparison, it can be seen that, in the case where the electroplating treatment on barrier layer is directly performed without performing the preparation of loose structure copper layer (02), there is no rough copper nodule structure on the surface, and the overall profile is low.

In this case, the loading of the battery active materials is low, and the wettability of the active materials is poor, which will affect the capacity as well as the life of the battery.

### Comparative example II

Compared with Embodiment I, the differences are that:
No additive for the roughening solution is added during the roughening treatment (S2.2).

The electrolytic copper foil finally obtained is product VIII.

Measure the thickness of product VIII, and the thickness is 7.8µm.

The SEM image of both sides A and B of product VIII is shown in FIG.13.

By comparison, it can be seen that, in the case where no additive for the roughening solution is added, the morphology of copper nodules has changed obviously. The copper nodule particles are coarse, and there are few gaps between the copper nodules.

In this case, compared with Embodiment I, the loading amount of the active materials in not optimal.

### Comparative example III

Compared with Embodiment I, the differences are that:
The process of the curing treatment (S2.3) is omitted.

The electrolytic copper foil finally obtained is product IX.

Measure the thickness of product IX, and the thickness is 7.1 µm.

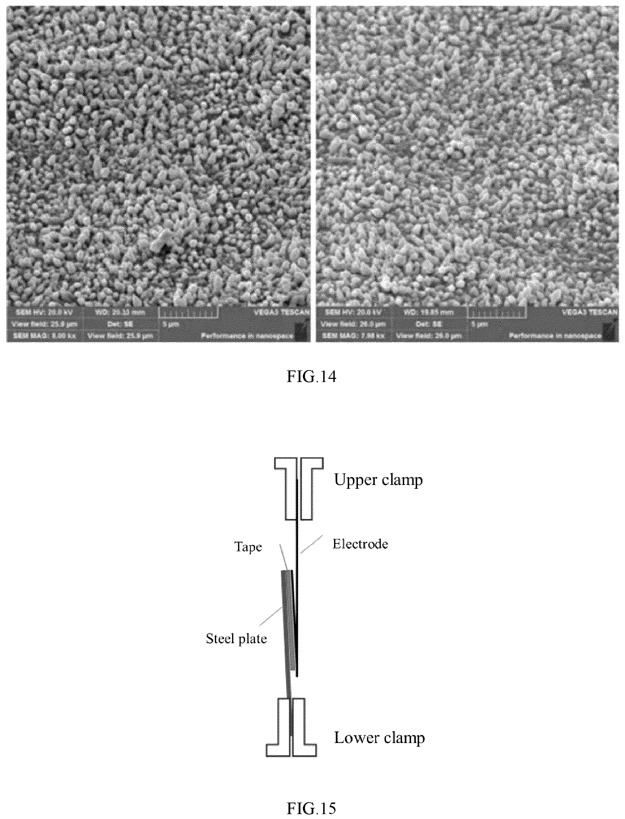

The SEM image of both sides A and B of product IX is shown in FIG.14.

By comparison, it can be seen that, the copper nodule particles are fine in general in the case where curing is not performed.

In this case, compared with Embodiment I, the loading amount of the active materials in not optimal.

### Comparative example IV

Compared with Embodiment IV, the differences are that:
After the completion of the preparation (S1) of dense copper layer I by electrolyzing raw foil, do not perform the preparation (S2) of loose structure copper layer (02), and directly perform electroplating treatment on barrier layer and modified barrier layer without changing electroplating process parameters.

The electrolytic copper foil finally obtained is product X.

### Comparative example V

Compared with Embodiment IV, the differences are that:
After the completion of the preparation (S1) of dense copper layer I by electrolyzing raw foil, in the process of roughening treatment (S2.2) of the loose structure copper layer (02) in S2, there is no additive in the roughening solution. The other processes are the same.

The electrolytic copper foil finally obtained is product XI.

### Comparative example VI

Compared with Embodiment IV, the differences are that:
After the completion of the preparation (S1) of dense copper layer I by electrolyzing raw foil, the process of the curing treatment (S2.3) of the loose structure copper layer (02) in S2 is omitted. The other processes are the same.

The electrolytic copper foil finally obtained is product XII.

### Comparative example VII

Compared with Embodiment IV, the differences are that:
After the completion of the preparation (S1) of dense copper layer I by electrolyzing raw foil, perform the preparation (S2) of loose structure copper layer (02) and the preparation (S3) of barrier layer, but the treatment of modified barrier layer is not performed. The other processes are the same.

The electrolytic copper foil finally obtained is product XIII.

In order to further define the product performance, performance tests for product I to product XIII are performed according to the following methods, and the results are summarized in Table 1 and Table 2.

### 1. Method for measuring the thickness of copper foil.

Take a sample of 1280*20cm full width copper foil. Take copper foil samples with a size 10*10cm2 at ten equally spaced positions. Measure using a precision thickness gauge, and finally take the average value.

### 2. Method for measuring the surface roughness.

According to the measurement method GB/T29847-2013, use Japan Mitutoyo portable roughness meter SJ-210 to test the value of roughness Rz of the treated copper foil surface. Measure the roughness value of three points, and take the average value.

### 3. Method for measuring the specific surface area and Spd.

According to ISO25178-2012 method, use laser confocal OLS5000 with an objective magnification of 50x (X50) in face sweep mode to obtain the specific surface area and Spd data of the copper foil surface of the samples to be tested. Take the values measures at three points, and then take the average value.

### 4. Method for measuring the contact angle.

Take a sample of 1280*20cm full width copper foil. Take copper foil samples with a size 10*10cm2 at ten equally spaced positions. Measure the water droplet contact angle using a KZS-20 contact angle tester, and finally take the average value.

### 5. Method for measuring the peeling strength of active materials.

Cut the pole piece obtained by rolling copper foil and electrode materials into 400mm*15mm. Adhere the pole piece on the steel plate with double-sided tape. The width of the double-sided tape is equal to that of the pole piece. Clamp the free end of the pole piece and the steel plate on the upper and lower grippers of an all-purpose tensile tester, separately.

A schematic diagram of the peeling strength test is shown in FIG. 15. The peeling length of the pole piece is 50 mm, and the peeling speed is 100 mm/min.

The value of the tensile obtained by the test is the peeling strength of the electrode material from the copper foil. The peeling strength is taken as the average of ten tests.

### 6. Method for measuring the tensile strength/elongation.

Cut the copper foil into sample strips of size 10*1.3cm2 using a cutting machine. Use a tensile tester to measure the tensile strength of the copper foil. The tensile strength/elongation is taken as the average of ten tests.

### 7. Method for measuring the peeling strength of a sheet.

Cut the sheet obtained by laminating a copper foil sample with an epoxy resin substrate (Shengyi Technology Semi-cured S1150) into sample strips with a width of 5mm. Use a tensile tester to measure the peeling strength between the copper foil and the prepreg. The peeling strength is taken as the average of ten tests.

The results of performance tests of each sample of the embodiments are summarized in Table 1.

**Table 1. Comparison of the performance of embodiments of the copper foil having double-sided loose structure**

| | Embodi ment I | Embodi ment II | Embodi ment III | Embodi ment IV | Embodi ment V | Embodi ment VI |
|---|---|---|---|---|---|---|
| Thickn ess of copper foil (µm) | 6.7 | 9.2 | 5.8 | 36.9 | 11.1 | 72.2 |
| Rz of side A (µm) | 2.9 | 2.8 | 2.9 | 2.7 | 2.8 | 2.8 |
| Specifi c surface area of side A | 1.5 | 1.4 | 1.5 | 1.5 | 1.4 | 1.4 |
| Spd of side A (1/mm2 ) | 31700 | 33500 | 33900 | 30800 | 34000 | 33200 |
| Contac t angle of side A(°) | 0-10 | 0-10 | 0-10 | 0-10 | 0-10 | 0-10 |
| Peeling strengt h of active materia Is of side A (N/mm) | 23.3 | 25.7 | 20.1 | - | - | - |
| Peeling strengt h of sheet of side A (N/mm) | - | - | - | 1.15 | 1.07 | 1.75 |
| Rz of side B (µm) | 3.0 | 2.9 | 3.0 | 2.9 | 2.8 | 2.8 |
| Specifi c surface area of side B | 1.6 | 1.5 | 1.4 | 1.4 | 1.5 | 1.5 |
| Spd of side B (1/mm2 ) | 35200 | 32500 | 33700 | 31200 | 33500 | 34000 |
| Contac t angle of side B (°) | 0-10 | 0-10 | 0-10 | 0-10 | 0-10 | 0-10 |
| Peeling strengt h of active materia Is of side B (N/mm) | 22.7 | 28.7 | 23.3 | - | - | - |
| Peeling strengt h of sheet of side B (N/mm) | - | - | - | 1.13 | 0.98 | 1.69 |
| Tensile strengt h (Mpa) | 601 | 543 | 657 | 471 | 513 | 438 |
| Elongat ion (%) | 6.2 | 6.9 | 3.9 | 11.5 | 7.2 | 14.3 |

The results of performance tests of each sample of the comparative examples are summarized in Table 2

**Table 2. Comparison of the performance of comparative examples of the copper foil having double-sided loose structure**

| | Compar ative Exampl e I | Compar ative Exampl e II | Compar ative Exampl e III | Compar ative Exampl e IV | Compar ative Exampl eV | Compar ative Exampl e VI | Compar ative Exampl e VII |
|---|---|---|---|---|---|---|---|
| Thickne ss of copper foil (µm) | 6.1 | 7.8 | 6.8 | 35.1 | 36.8 | 36.1 | 37.1 |
| Rz of side A (µm) | 0.9 | 2.1 | 1.5 | 1.1 | 2.3 | 1.8 | 2.8 |
| Specific surface area of side A | 1.0 | 1.2 | 1.1 | 1.1 | 1.3 | 1.2 | 1.4 |
| Spd of side A (1/mm2) | 210 | 17200 | 21300 | 375 | 15600 | 28700 | 33800 |
| Contact angle of side A (°) | 57 | 0-10 | 0-10 | 61 | 0-10 | 0-10 | 0-10 |
| Peeling strength of active material | 10.5 | 15.4 | 14.2 | - | - | - | - |
| s of side A (N/mm) | | | | | | | |
| Peeling strength of sheet of side A (N/mm) | - | - | - | 0.22 | 1.08 | 0.95 | 0.75 |
| Rz of side B (µm) | 1.2 | 2.3 | 1.7 | 1.1 | 2.4 | 1.8 | 2.8 |
| Specific surface area of side B | 1.0 | 1.2 | 1.1 | 1.0 | 1.3 | 1.2 | 1.5 |
| Spd of side B (1/mm2) | 130 | 19700 | 22570 | 270 | 18500 | 23500 | 33700 |
| Contact angle of side B (°) | 48 | 0-10 | 0-10 | 52 | 0-10 | 0-10 | 0-10 |
| Peeling strength of active material s of side B (N/mm) | 7.9 | 15.6 | 14.7 | - | - | - | - |
| Peeling strength | - | - | - | 0.25 | 1.06 | 0.87 | 0.70 |
| of sheet of side B (N/mm) | | | | | | | |
| Tensile strength (Mpa) | 608 | 601 | 599 | 471 | 481 | 470 | 473 |
| Elongati on (%) | 6.4 | 7.1 | 7.8 | 11.5 | 9.5 | 10.3 | 9.7 |

Based on the performance indexes and microstructure of Table 1 and Table 2, it can be seen that:

### Comparison between Embodiment I and Comparative example I:

It is obvious that the roughness, specific surface area and number of peaks per unit area (Spd) of Embodiment I are higher than those of the copper foil with two smooth surfaces (Comparative example 1), which means that the electrolytic copper foil having double-sided loose structure prepared by the present disclosure has better adhesion strength with electrode materials.

Meanwhile, by comparing the data of contact angle, it can be seen that the wettability of copper foil having double-sided loose structure is better.

### Comparison between Embodiment I and Comparative example II:

No roughening additive is added in Comparative example II, and thus the roughness, specific surface area and Spd index of the treated foil surface are all lower than those of Embodiment I. Meanwhile, it can be seen that the peeling strength of active materials of Comparative example II is lower than that of Embodiment I, but higher than that of Comparative example I.

This shows that the roughening additive can regulate the morphology of roughened copper nodules and form a structure with discrete and high specific surface area. Such a kind of microstructure is in favor of anchoring electrode materials, increasing the adhesion of the electrode materials and prolonging the life of the battery. Meanwhile, a large specific surface area is beneficial to the rapid transmission of electrons in the electrode materials, reducing the internal resistance of the battery, enhancing the rapid charging and discharging performance of the battery, reducing the heat generated during the charging and discharging process of the battery, and improving the safety.

The above comparison shows the necessity of adding additives to the roughening solution.

### Comparison between Embodiment I and Comparative example III:

The roughness and specific surface area of Comparative example III are small, and the test value of the peeling strength is lower than that of Embodiment I, which proves that the step of curing in the surface treatment process of the present disclosure is essential. The curing process is beneficial to the growth of copper nodules, and is in favor of improving roughness and specific surface area, and increasing adhesion between active materials and the copper foil.

Comparing the copper foil having double-sided loose structure (Embodiment I, Comparative example II and Comparative example III) with the copper foil with two smooth surfaces (Comparative example I), it can be seen that:

The obviously rough surface has better wettability, and good wettability has the advantage of improving the compatibility between copper foil and electrode materials, which may improve the performance and life of the battery when used in a lithium ion battery.

In Embodiment IV, Embodiment V, and Embodiment VI, the peeling strength between copper foil and substrate are tested by pressing plate, and values of the peeling strength between sides A and B of the copper foil and the substrate are close, both of which are greater than 0.75N/mm. This indicates the peeling strength between the two sides of the copper foil and the substrate is good. When applied to a printed circuit board, the peeling strength of electrolytic copper foil having double-sided loose structure can meet the requirements without performing browning process on the copper foil.

### Comparison between Embodiment IV and Comparative example IV:

It is obvious that the roughness, specific surface area and number of peaks per unit area (Spd) of Embodiment IV are higher than those of the copper foil with two smooth surfaces without loose structure (Comparative example IV). The peeling strength between the electrolytic copper foil having double-sided loose structure and the sheet is greater.

### Comparison between Embodiment IV and Comparative example V:

Similar to the surface treatment of Comparative example II, no roughening additive is added in Comparative example V, and thus the roughness, specific surface area and Spd index of the treated foil surface are all lower than those of Embodiment IV. Meanwhile, it can be seen that the peeling strength of the two-sided sheet materials is also lower than that of Embodiment IV, but higher than that of Comparative example IV.

The above comparison shows the necessity of adding additives to the roughening solution.

### Comparison between Embodiment IV and Comparative example VI:

The roughness and specific surface area of Comparative example VI are small, and the test value of the peeling strength of the sheet material is lower than that of Embodiment IV, which proves that the step of curing in the surface treatment process is essential.

### Comparison between Embodiment IV and Comparative example VII:

The roughness, specific surface area and Spd index of the two surfaces of the copper of Comparative example VII are equivalent to those of Embodiment IV, while the peeling strength of the sheet material of Comparative example VII is obviously low, which proves the necessity of modified silane layer in the surface treatment process.

Comparing the tensile strength and elongation of dense copper layer with the final product after surface treatment, the changes of tensile strength and elongation are small, which means that the surface treatment process has little effect on the tensile strength and elongation of copper foil.

Through the above examples, it can be explained that the electrolytic copper foil of the present disclosure has high roughness, large specific surface area and good wettability, and can be well applied to lithium ion batteries and printed circuit boards, and has obvious advantages compared with the traditional copper foil.

Finally, it should be emphasized that the above is merely preferred embodiments of the present invention, which is not used to limit the present disclosure. For those skilled in the art, the present invention can have various changes and modifications, and any modification, equivalent substitution, and improvement made within the spirit and principle of the present invention should be included in the protection scope of the present disclosure.

## Claims

1. An electrolytic copper foil having double-sided loose structure, comprising:
a dense copper layer (01);
a loose structure copper layer (02), grown on two surfaces of the dense copper layer (01); and
a barrier layer (03), coated on the loose copper layer (02),
wherein the loose structure copper layer (02) comprises loose structure, and the morphology of the loose structure is a combination of one or more of needle tip, round granule, long granule, whisker and cluster.

2. The electrolytic copper foil of claim 1, wherein an overall thickness of the dense copper layer (01) and the electrolytic copper foil is 4.5 µm-70 µm, and a thickness of the loose structure copper layer (02) is 0.5µm-2µm.

3. The electrolytic copper foil of claim 1, wherein a composition of the barrier layer (03) comprises chromium; and wherein the loose structure is copper nodule particles, and the copper nodule particles are uniformly distributed on surfaces of the dense copper layer (01) and are independent of each other.

4. The electrolytic copper foil of claim 1, further comprising:
a modified barrier layer (04), formed by applying a silicone-containing organic coating to a surface layer of the barrier layer (03) and modifying, wherein the modified barrier layer (04) is silicone-containing organic coating.

5. The electrolytic copper foil of claim 4, wherein a composition of the modified barrier layer (04) includes at least two of the following: epoxy silane, amino-silane, mercapto-silane, vinyl silane, cyano-silane, and methacryloyloxy-silane.

6. The electrolytic copper foil of claim 4, wherein a composition of the barrier layer (03) comprises one or more of chromium, zinc, tin, molybdenum, cobalt, tungsten, and nickel.

7. The electrolytic copper foil of any of claims 1-6, wherein,
the dense copper layer (01) is configured to comprise at least one of the following:
a tensile strength of the dense copper layer (01) ranging from 475Mpa to 685Mpa,
an elongation of the dense copper layer ranging from 3.5% to 16.8%,
a roughness of the dense copper layer obtained by smooth surface contact method ranging from 0.8µm to 1.5µm,
a roughness of the dense copper layer obtained by rough surface contact method ranging from 0.8µm to 1.3µm; and wherein,
the loose structure copper layer (02) comprises an upper layer and a lower layer, and the loose structure copper layer (02) is configured to comprise at least one of the following:
a roughness of the loose structure copper layer (02) obtained by a method of contacting the upper surface and the lower surface of the loose structure copper layer (02) being greater than 2.7µm,
a specific surface area of the loose structure copper layer (02) obtained by non-contact method being above 1.3,
a number of peaks per unit area (Spd) of the loose structure copper layer (02) ranging from 30,000/mm² to 40,000/mm².

8. A method for manufacturing an electrolytic copper foil having double-sided loose structure, comprising:
electrolyzing a raw foil to prepare a dense copper layer (01);
pretreating the dense copper layer (01), so as to generate a loose structure copper layer (02) on the pretreated dense copper layer (01);
electrochemically depositing a metal on the loose structure copper layer (02), to form a barrier layer (03) coated on the loose structure copper layer (02); and
washing and drying to obtain the electrolytic copper foil having double-sided loose structure,
wherein the loose structure copper layer (02) comprises loose structure, and the morphology of the loose structure is a combination of one or more of needle tip, round granule, long granule, whisker and cluster.

9. The method of claim 8, wherein electrolyzing a raw foil to prepare a dense copper layer (01) comprises:
preparing an electrolyte; and
prepare the dense copper layer (01) of a copper foil having two smooth surfaces by an electrolytic machine, the dense copper layer (01) having a predetermined thickness,
wherein, the electrolyte comprises: a first solvent and a second solvent, the first solvent comprising a combination of any two or three of collagen, hydroxyethyl cellulose, polyethyleneimine, polyethylene glycol, sulfamic acid, ammonium iminodiacetate, polyetheramine, and polyetherimide, and the second solvent comprising at least one of thiourea, sodium sulfite, sodium sulfide, sodium polydithiodipropane sulfonate, and N-hydroxyethylbenzenesulfonamide, and wherein a mass ratio of the first solvent and the second solvent is 3:1 and a total concentration of the electrolyte ranges from 30mg/L to 50mg/L.

10. The method of claim 8, wherein pretreating the dense copper layer (01) comprises:
pickling the dense copper layer (01) to wash off an oxide layer on the surface of the dense copper layer (01);
performing a roughening treatment on the pickled dense copper layer (01), and plating copper nodule particles on the surface of the dense copper layer (01) by applying electric current to form a preliminarily roughened dense copper layer (01);
washing the preliminarily roughened dense copper layer (01) with water; and
fixing the copper nodule particles to prevent the copper nodule from falling off the surface of the dense copper layer (01).

11. The method of claim 10, wherein the loose structure is copper nodule particles, and the copper nodule particles are uniformly distributed on surfaces of the dense copper layer (01) and are independent of each other.

12. The method of claim 10, wherein pretreating the dense copper layer (01) further comprises:
applying current to the surface of the dense copper layer (01) to perform smooth copper plating treatment, and continuously improving roughness of the copper nodule particles; and
adjusting thickness of the dense copper layer (01) by roughening and curing current magnitude.

13. The method of claim 10, wherein generating a loose structure copper layer (02) on the pretreated dense copper layer (01) comprises:
washing the pretreated dense copper layer (01) to form the loose structure copper layer (02) on the pretreated dense copper layer (01).

14. The method of claim 8, wherein the metal comprises one or more of chromium, zinc, tin, molybdenum, cobalt, tungsten, and nickel.

15. The method of claim 10, wherein performing a roughening treatment on the pickled dense copper layer (01) comprises:
performing a roughening treatment on the pickled dense copper layer (01) by using an additive for roughening solution, wherein the additive for roughening solution comprises two or three of: sodium molybdate, sodium tungstate, polyvinyl alcohol, polyvinyl pyrrolidone, and polypyrrole, and a total concentration of the additive for roughening solution ranges from 10mg/L to 30mg/L.

16. The method of claim 8, further comprising:
applying a silane treatment agent on surface of the barrier layer (03) to form a modified barrier layer (04) on the surface of the barrier layer (03), wherein the modified barrier layer (04) comprises silicone-containing organic coating.

17. The method of claim 16, wherein the silane treatment agent comprises a first component and a second component, wherein the first component and the second component are any two of epoxy silane, amino-silane, mercapto-silane, vinyl silane, cyano-silane, and methacryloyloxy-silane, a ratio of mass concentration of the first component and the second component ranges from 1:1 to 1:3.

18. The method of claim 17, wherein the silane treatment agent is configured to comprise at least one of the following:
a total concentration of the silane treatment agent is 1.5wt%;
and a concentration of silicon after full hydrolysis in the silane treatment agent ranges from 0.5g/L to 2g/L.

19. A lithium ion battery, wherein the lithium ion battery comprises the electrolytic copper foil of any one of claims 1-3 and 7.

20. A printed circuit board, wherein the printed circuit board comprises the electrolytic copper foil of any one of claims 4-7.
